# EUROPEAN PATENT SPECIFICATION

(11) **EP 3 884 503 B1**
(45) Date of publication and mention of the grant of the patent: **10.04.2024**
(21) Application number: 19886846.5
(22) Date of filing: 18.11.2019
(51) Int. Cl.: G21C 3/07, C23C 14/06, C23C 14/18, C23C 14/34, C04B 41/50, C04B 41/51, C04B 41/52, C04B 41/88, C04B 41/90

(54) **COATINGS AND SURFACE MODIFICATIONS TO MITIGATE SIC CLADDING DURING OPERATION IN LIGHT WATER REACTORS**
BESCHICHTUNGEN UND OBERFLÄCHENMODIFIKATIONEN ZUR VERMINDERUNG DER SIC-KASCHIERUNG WÄHREND DES BETRIEBS IN LEICHTWASSERREAKTOREN
REVÊTEMENTS ET MODIFICATIONS DE SURFACE POUR RENFORCER UNE GAINE EN SIC PENDANT LE FONCTIONNEMENT DANS DES RÉACTEURS À EAU LÉGÈRE

(30) Priority: 20.11.2018 US 201816196005
(43) Date of publication of application: 29.09.2021
(73) Proprietor: Westinghouse Electric Company LLC, Cranberry Township, PA 16066 (US); Wisconsin Alumni Research Foundation, Madison, WI 53726 (US)
(72) Inventor: LAHODA, Edward J., EDGEWOOD, PA 15218 (US); XU, Peng, Columbia, SC 29229 (US); OELRICH, Robert L., Jr., Columbia, SC 29223 (US); YEOM, Hwasung, Madison, WI 53705 (US); SRIDHARAN, Kumar, Madison, WI 53706 (US)
(74) Representative: Fleuchaus & Gallo Partnerschaft mbB
(86) International application number: PCT/US2019/061947
(87) International publication number: WO 2020/106606

(56) References cited:
- US-A- 5 912 935
- US-A1- 2016 049 211
- US-A1- 2017 159 186
- US-A1- 2017 358 372
- US-A1- 2018 257 997
- RASHKEEV SERGEY N ET AL: "Ultra-high temperature steam corrosion of complex silicates for nuclear applications: A computational study", JOURNAL OF NUCLEAR MATERIALS, ELSEVIER B.V, NETHERLANDS, vol. 444, no. 1, 18 September 2013 (2013-09-18), pages 56-64, XP028785826, ISSN: 0022-3115, DOI: 10.1016/J.JNUCMAT.2013.09.021
- ANG CAEN ET AL: "Electroplating chromium on CVD SiC and SiCf-SiC advanced cladding via PyC compatibility coating", JOURNAL OF NUCLEAR MATERIALS, ELSEVIER B.V, NETHERLANDS, vol. 503, 6 March 2018 (2018-03-06), pages 245-249, XP085375917, ISSN: 0022-3115, DOI: 10.1016/J.JNUCMAT.2018.03.009

## Description

### GOVERNMENT SUPPORT

This invention was made with U.S. government support under DE-NE0008800, DE-NE0008300, and DE-NE0008222, awarded by the Department of Energy (DOE). The United States government has certain rights in the invention.

### CROSS-REFERENCE TO RELATED APPLICATIONS

This application claims priority from United States Utility Patent Application Serial No. 16/196,005 filed November 20, 2018.

### BACKGROUND

### 1. Field

This invention relates generally to nuclear reactors and more particularly to silicon carbide cladding in operating light water nuclear reactors.

### 2. Related Art

In a typical light water nuclear reactor, such as a pressurized water reactor (PWR), the reactor core includes a large number of fuel assemblies, each of which is composed of a plurality of elongated fuel elements or fuel rods. Fuel assemblies vary in size and design depending on the desired size of the core and the size of the reactor. The fuel rods each contain nuclear fuel fissile material, such as at least one of uranium dioxide (UO₂), plutonium dioxide (PuO₂), thorium dioxide (ThO₂), uranium nitride (UN) and uranium silicide (U₃Si₂) or mixtures thereof. At least a portion of the fuel rods can also include neutron absorbing material, such as, boron or boron compounds, gadolinium or gadolinium compounds, erbium or erbium compounds and the like. The neutron absorbing material may be present on or in pellets in the form of a stack of nuclear fuel pellets. Annular or particle forms of fuel also can be used.

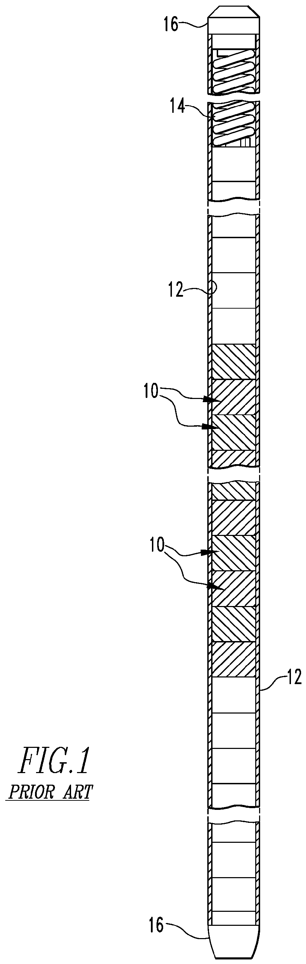

Each of the fuel rods has a cladding that acts as containment to hold the fissile material. The cladding of each fuel rod has a plug or cap positioned at each end. Further, a hold down device, such as a metal spring, is provided in the fuel rod to maintain the configuration of the stack of nuclear fuel pellets. FIG. 1 illustrates a prior art design of a fuel rod which shows a zirconium-based cladding 12 with end plugs 16, having positioned inside the cladding 12, a stack of fuel pellets 10 and a spring hold down device 14. One of the end plugs 16, i.e., the one positioned closest to the hold down device 14 is typically referred to as the top end plug. The fuel rods are grouped together in an array which is organized to provide a neutron flux in the core sufficient to support a high rate of nuclear fission and thus, the release of a large amount of energy in the form of heat. A coolant, such as water, is pumped through the reactor core to extract the heat generated in the reactor core for the production of useful work such as electricity.

The cladding on the fuel rods may be composed of zirconium (Zr) and may include as much as about two percent by weight of other metals, such as niobium (Nb), tin (Sn), iron (Fe) and chromium (Cr). Recent developments in the art have provided fuel rod cladding composed of a ceramic-containing material, such as silicon carbide (SiC). SiC has been shown to exhibit desirable properties in beyond design basis accidents, e.g., a temperature of greater than 1200 °C and therefore, may be considered a suitable material of construction for nuclear fuel rod claddings. However, maintaining fission gas impermeability during flexing induced by handling or accidents or natural phenomena, such as earthquakes, is difficult due to the natural inelasticity of ceramic materials generally. Fastening end plugs on SiC tubes in a high throughput, economic manner yielding a hermetic seal at temperatures beyond 1200 °C is also difficult. The use of an inner sleeve composed of a Zr alloy wrapped with SiC fibers has been attempted but has failed due to excessive corrosion encountered during chemical vapor infiltration (CVI) when SiC is deposited within and on the SiC fibers to hold them together. Thus, issues relating to nuclear fuel rod cladding have remained, including corrosion of the Zr tube at temperatures associated with a nuclear water reactor core, e.g., about 800 °C to about 1200 °C, and the chemical conditions, e.g., gas containing H₂, Cl₂ and HCl, encountered during the CVI process.

It has also been attempted to make the SiC winding separately, subject it to CVI, and then fit it over the Zr tube. However, there are issues with this approach as well. For example, the space between the Zr tube and the SiC composite matrix forms an additional heat transfer barrier within the cladding layer, which could cause fuel centerline melt at the very high linear heat generation rates encountered by nuclear fuel (normally greater than 5 kw/ft). Because the ends are not covered, there is a potential for the Zr tube to slip from the SiC composite sleeve and provide a pathway for high temperature steam and other gases to infiltrate below the SiC composite and attack the Zr alloy tube.

However, SiC-SiC composites are emerging as leading candidates for the replacement of Zr-alloy in light water reactors (LWRs)) as an accident tolerant fuel (ATF) cladding material. SiC composites are expected to extend coping time under a loss-of-coolant accident (LOCA) and other possible accident scenarios by virtue of high temperature steam corrosion resistance, excellent high temperature strength, and good radiation stability. Research and development of SiC-SiC composites has been focused in the areas of fabrication, end-cap joining, scalability and high temperature testing.

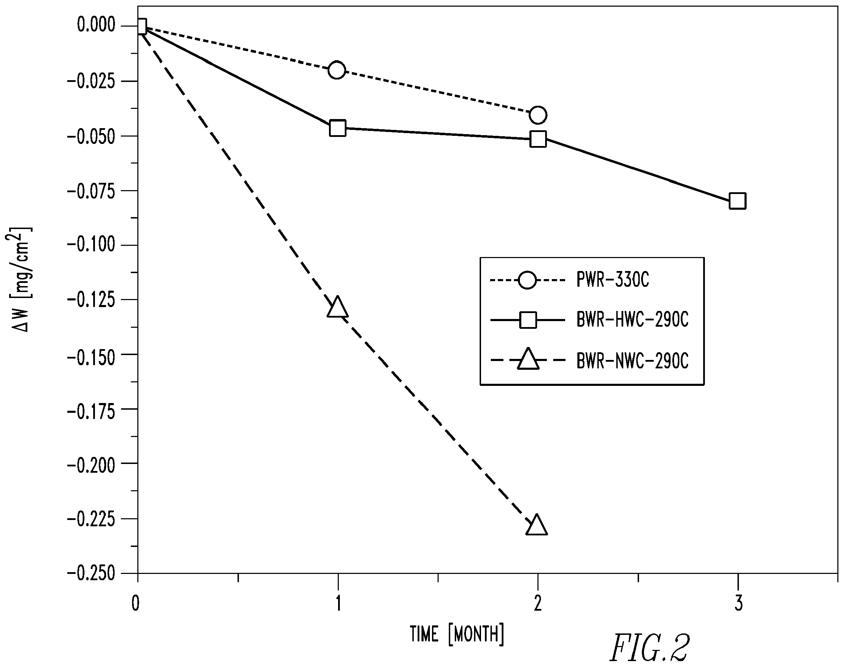

One design of the SiC cladding consists of an inner SiC-SiC composite (SiC fibers/matrix) for mechanical toughness, and an outer monolithic SiC coating for improved corrosion resistance and to serve as impermeable fission gas barrier. However, aqueous hydrothermal corrosion of SiC in water coolant is an important concern in normal operating conditions of the LWR. This is demonstrated in data shown in FIG. 2, which shows a loss in weight and thickness of SiC in prototypic aqueous LWR environments. This effect is attributed to the dissolution of the silica phase formed due to oxidation of SiC in reactor coolants. One probable silica formation reaction and dissolution pathway is as follows:

SiC₍ₛ₎ + 4H₂O_{(aq)} → SiO₂₍ₛ₎ + 4H_{2(g)} + CO_{2(g)} (1)

SiO₂₍ₛ₎ + 2H₂O_{(aq)} → Si(OH)_{4(aq)} (2)

High oxygen activity in the water coolant due to dissolved oxygen and radiolysis of water, and radiation damage can accelerate hydrothermal corrosion and recession of the SiC cladding surface. One approach to mitigate the SiC corrosion is to control water coolant chemistry. The following nuclear reactor simulated water chemistries are illustrated in FIG. 2: PWR at a temperature of 330 °C having 3.57 ppm H₂ and a pH of 7.2; BWR-HWC at a temperature of 290 °C having 0.3 ppm H₂ and a pH of 5.6; and BWR-NWC at a temperature of 290 °C having 1.0 ppm O₂ and a pH of 5.6. As demonstrated in FIG. 2, dissolving hydrogen in the water for example can reduce corrosion, though corrosion continues to occur at a slower rate and at microstructural defects (e.g. amorphous SiC) if present.

Moreover, it is found the pure SiC ceramic matrix composite (CMC) tubes are susceptible to microcracking and may lose hermeticity during handling and transportation. U.S. patent application publication no. 2017/0159186 A1 discloses a multilayer cladding including a combination of ceramic and metallic components. An inner layer forms a cladding structure, an intermediate layer includes a ceramic composite or ceramic-containing composite composed of interlocking woven or braided fibers and a matrix material, and an outer layer is composed of metal or metal alloy. Thus, a new SiC cladding design using a metallic or ceramic coating on the outside of SiC cladding is needed to mitigate the corrosion and hermeticity issues.

In the past there has been success in applying coatings on SiC-matrix composites for aerospace applications, i.e., plasma spray coatings of various oxides (e.g., yttrium oxide, alumina, zirconia). In accordance with the invention, similar coatings can be applied for SiC cladding to improve the corrosion and hermeticity issues.

### SUMMARY

In one aspect, the invention provides a composite silicon carbide cladding as claimed in claim 1.

In certain embodiments, the invention thus an aluminum coating applied to the outer surface of the silicon carbide substrate and a FeCrAl alloy coating applied to the aluminum coating; or an intermixed coating comprising Al₄C₃+Si and Fe-Al alloy applied to the outer surface of the silicon carbide substrate, a FeCrAl alloy coating applied to the intermixed coating, and a Cr₂O₃ coating applied to the FeCrAl alloy coating; or a CrN layer applied to the outer surface of the silicon carbide substrate and a chromium layer applied to the CrN layer, and one or more additional layers of alternating CrN and chromium layers.

In another aspect, the invention provides a method, as claimed in claim 2, of preparing a composite silicon carbide cladding for use in a light water nuclear reactor.

In certain embodiments, the invention thus includes depositing an aluminum coating on the outer surface of the silicon carbide substrate, and depositing a FeCrAl alloy coating on the aluminum coating; or depositing a CrN layer on the outer surface of the silicon carbide substrate and depositing a chromium layer on the CrN layer, and depositing one or more additional layers of alternating CrN and chromium layers thereon.

In certain embodiments, when the method includes depositing the aluminum coating on the outer surface of the silicon carbide substrate and depositing a FeCrAl alloy coating on the aluminum coating, the method further comprises heat treating the coating. This can comprise forming an intermixed coating comprising Al₄C₃+Si and Fe-Al alloy applied to the outer surface of the silicon carbide substrate, a FeCrAl alloy coating applied to the intermixed coating, and a Cr₂O₃ coating applied to the FeCrAl alloy coating. The heat treating step may be conducted at a temperature from 500 to 600 °C.

The coating can be applied by a process selected from the group consisting of cold spray, thermal spray, physical vapor deposition, DC reactive sputtering, and slurry coating.

### BRIEF DESCRIPTION OF THE DRAWINGS

A further understanding of the invention can be gained from the following description of the preferred embodiments when read in conjunction with the accompanying drawings in which:
FIG. 1 is a simplified schematic of a prior art nuclear reactor fuel rod design to which this invention can be applied;
FIG. 2 is a plot that illustrates weight loss of CVD-SiC in water autoclave tests for various water chemistries;
FIG. 3A is a simplified schematic of a multilayer coating architecture of a cold sprayed FeCrAl alloy coating with an aluminum bond layer as-deposited on a SiC substrate, in accordance with certain embodiments of the invention; and 3B is a simplified schematic of the multilayer coating architecture of FIG. 3A following heat treatment, in accordance with certain embodiments of the invention;
FIG. 4 is a simplified schematic of a multilayer coating architecture having alternating coating layers of Cr and CrN on a SiC substrate, in accordance with certain embodiments of the invention;
FIG. 5 is a plot illustrating free energy of formation for Zr and Y oxide; and
FIG. 6A is a simplified schematic of a multilayer coating architecture of a YSi layer as-deposited by physical vapor deposition on a SiC substrate, in accordance with certain embodiments of the invention; and FIG. 6B is a simplified schematic of the multilayer coating architecture of FIG. 6A following heat treatment, including a Y₂Si₂O₇ layer, in accordance with certain embodiments of the invention.

### DESCRIPTION OF THE PREFERRED EMBODIMENT

The invention provides novel SiC ceramic matrix composite (CMC) claddings with metallic, ceramic and/or multilayer coatings applied on the outer surface for improved corrosion resistance and hermeticity protection. The coating materials include one or more materials selected from FeCrAl, Y, Zr and Al-Cr alloys, Cr₂O₃, ZrO₂ and other oxides, chromium carbides, CrN, Zr- and Y-silicates and silicides. The coatings are applied employing a variety of known surface treatment technologies including cold spray, thermal spray process, physical vapor deposition process (PVD), and slurry coating.

SiC-SiC has outstanding high temperature strength and oxidation resistance, and well documented radiation damage response. Therefore, it is an excellent choice for LWR fuel cladding and core components from an accident tolerance standpoint. However, SiC-SiC also exhibits notable aqueous water corrosion under normal LWR operating conditions due to the thermodynamic instability of silicon-dioxide in this environment. Furthermore, the pure SiC CMC tube is also susceptible to microcracking due to its brittle nature.

The novel features of the invention address the aforementioned issues and concerns, as well as providing an improved SiC cladding.

The SiC cladding according to the invention consists of novel metallic or ceramic or multi-layer coatings on the outside of the cladding, e.g., outer surface. In certain embodiments, a FeCrAl alloy coating is deposited on a SiC cladding. The FeCrAl alloy coating is connected to, e.g., indirectly deposited on the SiC cladding, by being deposited on a bond layer of aluminium that is directly applied to the SiC cladding.

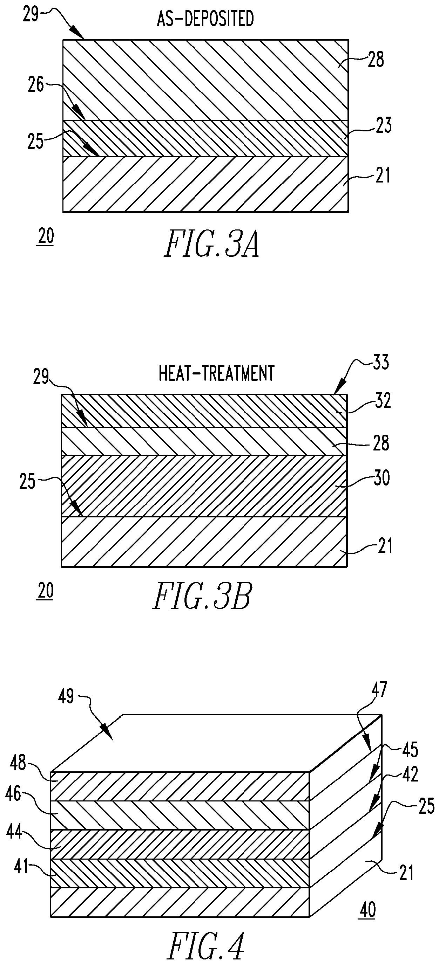

FIG. 3A illustrates a multilayer coating architecture 20 having a SiC substrate 21 with an outer surface 25 and a FeCrAl alloy coating 28 deposited on the SiC substrate 21. Additionally, the architecture 20 has deposited between the SiC substrate 21 and the FeCrAl alloy coating 28 an aluminum (Al) layer 23, e.g., a thin film or layer. The Al layer 23 is directly deposited on the outer surface 25 of the SiC substrate 21 and the FeCrAl alloy coating 28 is directly deposited on an outer surface 26 of the Al layer 23, wherein the Al layer 23 serves as a bond layer. The outer surface 29 of the FeCrAl alloy coating 28 serves as the exterior surface of the SiC CMC, which can be in contact with a coolant, such as water, pumped through a nuclear reactor core.

The novel metallic or ceramic or multi-layer coatings of the invention can be applied using conventional cold spray coating techniques. For example, the FeCrAl alloy coating 28 can be formed by a cold spray coating technique, and the Al (bond) layer 23 provides superior adhesion of the cold sprayed FeCrAl (metallic) alloy coating 28 to the SiC (ceramic) substrate 21.

Further adhesion improvement can be achieved by subjecting the architecture 20 as-deposited in FIG. 3A to a post-deposition heat treatment, e.g., from about 500 °C to about 600 °C, which promotes intermixing of the Al layer 23 with the FeCrAl alloy coating 28 and the SiC substrate 21 to increase the bond strength, dual-layered cold spray coating. FIG. 3B further illustrates the multilayer coating architecture 20 with heat treatment. FIG. 3B includes the SiC substrate 21 and the FeCrAl alloy coating 28 as shown in FIG. 3A. In addition, FIG. 3B shows an intermixed middle layer 30 positioned between the SiC substrate 21 and the FeCrAl alloy coating 28, which as a result of the heat treatment, is composed of Al₄C₃+Si and Fe-Al alloy. The intermixed middle layer 30 is directly deposited on the outer surface 25 of the SiC substrate 21. A Cr₂O₃ layer 32 is formed on the outer surface 29 of the FeCrAl alloy coating layer 28, such that the outer surface 33 of the Cr₂O₃ layer 32 forms the exterior surface of the SiC CMC, which can be in contact with a coolant, such as water, pumped through a nuclear reactor core.

As an alternative to cold spray deposition, a thermal spray process may be used in the invention. The thermal spray process generally includes melting the powder feed by a concentrated heat source to form molten particles, and spraying the molten particles on the surface of a substrate to form a dense coating. The process is widely used in industry for the deposition of ceramic coatings on ceramic and hard metal substrates. Likewise, thermal spray can be used to deposit ceramic and metalloid coating materials such as Cr, Y, Zr, Cr₂O₃, ZrO₂, Cr₃C₂, CrSi₂, Y₂Si₂O₇, Y₂Si₃O₉ and YSi₂ onto SiC cladding in accordance with certain embodiments of the invention.

For example, Y₂Si₂O₇ is highly stable in LWR coolants since silicon (Si) is highly immobile in the silicate phases of high temperature water systems. The thermal expansion coefficients of Y₂Si₂O₇ and SiC are similar, i.e., between 4 and 5 × 10⁻⁶ / °C for Y₂Si₂O₇ and 4.3 to 5.4 × 10⁻⁶ / °C for SiC, which indicates there will be minimal thermal stresses in the coating. The silicate coating will result in minimal neutron penalty because the neutron cross-section of yttrium is less than half of zirconium.

In accordance with the invention. Physical Vapor Deposition (PVD) with or without thermal conversion can be used for coating application. In general, the PVD process can deposit a wide range of coating materials with a high degree of compositional and microstructural control, uniformity and purity. Energetic ions generated (generally argon) bombard a target material, and the sputtered target atoms condense on a substrate and form a thin coating, for example, of the following materials: ZrSi₂, and YSi₂. The two silicide coatings are converted at high temperatures to highly corrosion-resistant ZrSiO₄ and Y₂Si₂O₇.

Furthermore, the corrosion resistance of thin PVD-applied CrN coatings has been shown to be superior to films of other nitrides such as TiAlN, TiN, and AlCrN in water autoclave tests for zirconium substrates. In accordance with the invention, a PVD process can be used to deposit the aforementioned chromium nitride (CrN) coating to SiC. Alternatively, the CrN coating can also be produced by Direct Current (DC) Reactive Sputtering, wherein a commercial Cr target is sputtered by Ar gas (for Cr) and a mixture of nitrogen and argon (for CrN) under voltage bias to increase deposition rate of the coating.

In certain embodiments, a Cr-CrN multilayer coating may be deposited on a SiC cladding surface. FIG. 4 illustrates a multilayer coating architecture 40 having a SiC substrate 21 (base layer as shown in FIGS. 3A and 3B) with an outer surface 25 and a first CrN coating 41 deposited on the outer surface 25 of the SiC substrate 21. A first Cr layer 44 is applied to an outer surface 42 of the first CrN coating 41. A second CrN layer 46 is applied to an outer surface 45 of the first Cr layer 44, and a second Cr layer 48 is applied to an outer surface 47 of the second CrN layer 46. An outer surface 49 of the second Cr layer 48 serves as the exterior surface of the SiC CMC, which can be in contact with a coolant, such as water, pumped through a nuclear reactor core.

Without intending to be bound by any particular theory, it is believed that in the multilayered coating architectures, crack propagation is arrested by the interfaces which would enhance the durability of coatings against corrosion.

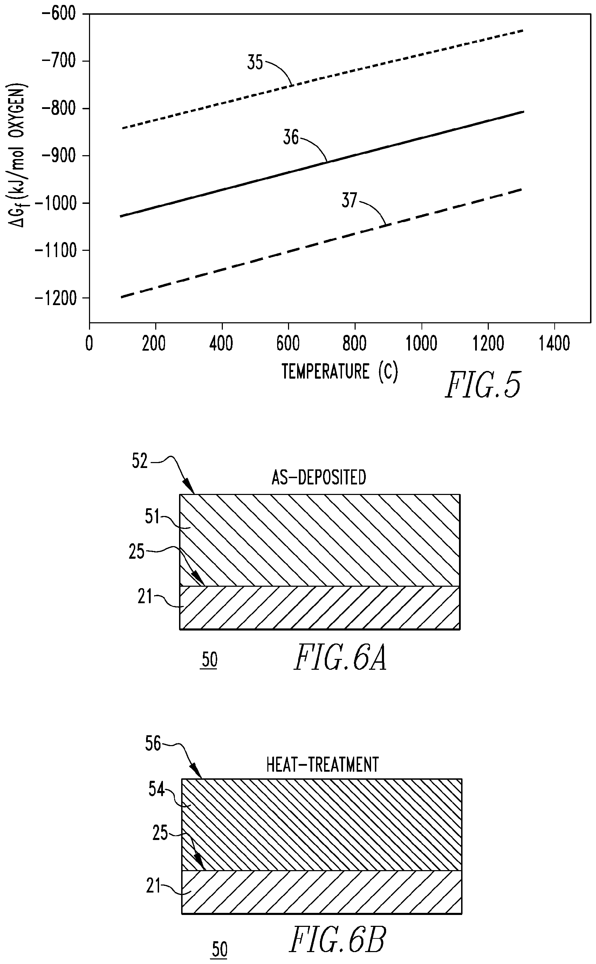

In accordance with the invention, subjecting a deposited multilayer coating architecture to a post-coating heat treatment can result in improved corrosion-resistance of a SiC cladding. Treatment at high temperatures thermally converts the coating structure and composition as-deposited to a more corrosion-resistant configuration. For example, a PVD deposited zirconium silicide (Zr-silicide) and yttrium silicide (Y-silicide) can be thermally converted to Zr-silicate coatings and Y-silicate coatings, respectively. FIG. 5 illustrates that free energy of formation for Zr- and Y- oxide as shown by 36 and 37, respectively, is more negative than SiO₂, as shown by 35. Therefore, unlike many transition metal silicides, the oxidation of Zr- or Y- silicides results in mixed metal/silicon oxide instead of a SiO₂ layer. As a result, the formation of metal silicates (ZrSiO₄ or Y₂Si₂O₇) is thermodynamically favored. It has been demonstrated that a dense ZrSiO₄ layer can be formed on a chemical vapor deposition (CVD) SiC surface by oxidation of a thin PVD ZrSi₂ coating at a temperature of 1400 °C for 5 hours in ambient air. The ZrSiO₄ top layer completely immobilizes Si in a pressurized steam environment, rendering it largely immune to corrosion.

Similarly, formation of a yttrium-silicate layer is facilitated by post-heat treatments of yttrium-silicide coatings. FIG. 6A illustrates a multilayer coating architecture 50 having a SiC substrate 21 with an outer surface 25 and a YSi coating 51 deposited on the outer surface 25 of the SiC substrate 21. The outer surface 52 of the YSi coating 51 serves as the exterior surface of the SiC CMC. As aforementioned, the YSi coating 51 can be formed by a conventional PVD technique. FIG. 6B illustrates the multilayer coating architecture 50 of FIG. 6A following heat treatment. The heat treated architecture 50 in FIG. 6B includes the SiC substrate 21 as shown in the as-deposited architecture in FIG. 6A. Further, the heat treated architecture 50 in FIG. 6B shows Y₂Si₂O₇ layer 54 deposited on the SiC substrate 21 as a result of the heat treatment, such that the outer surface 56 of the Y₂Si₂O₇ layer 54 forms the exterior surface of the SiC CMC, which can be in contact with a coolant, such as water, pumped through a nuclear reactor core.

Another alternative coating method is application of a slurry coating to a substrate. This processing technique is commonly referred to as Polymer Derived Ceramics (PDCs). It is an attractive alternative due to its relatively low cost, ability to perform near net-shape molding, and fabrication for complex structures, high-purity starting materials and relatively low processing temperatures (<1200 °C). PDC coatings, in the amorphous and crystalline phases, are generally of growing interest for corrosion, oxidation, and wear protection for porous non-oxidic ceramics and refractory metals.

In accordance with certain embodiments of the invention, PDC, such as silicon organometallic polymer, ethylene bis stearamide (EBS), an organic compound with the formula (CH₂NHC(O)C₁₇H₃₅)₂ can be used as polymer precursors. The corrosion resistance and fracture toughness can be further improved by using filler materials, such as TiO₂, Cr₂O₃, ZrO₂, Cr, Ti, CrAl alloy, Zr alloy, ZrO₂, and the like.

While specific embodiments of the invention have been described in detail, it will be appreciated by those skilled in the art that various modifications and alternatives to those details could be developed in light of the overall teachings of the disclosure. Accordingly, the particular embodiments disclosed are meant to be illustrative only and not limiting as to the scope of the invention which is to be given the full breadth of the appended claims.

## Claims

1. A composite silicon carbide cladding in a light water nuclear reactor, comprising:
a silicon carbide substrate (21) having an outer surface (25), the silicon carbide substrate (21) comprising a silicon carbide ceramic matrix composite; and
a coating applied to the outer surface (25) of the silicon carbide substrate (21),
**characterized in that**
the coating comprises:
an aluminum coating (23) applied to the outer surface (25) of the silicon carbide substrate (21), and a FeCrAl alloy coating (28) applied to the aluminum coating (23); or
an intermixed coating (30) comprising Al₄C₃+Si and Fe-Al alloy applied to the outer surface (25) of the silicon carbide substrate (21), a FeCrAl alloy coating (28) applied to the intermixed coating (30), and a Cr₂O₃ coating (32) applied to the FeCrAl alloy coating (28); or
a CrN layer (41) applied to the outer surface (25) of the silicon carbide substrate (21) and a chromium layer (44) applied to the CrN layer (41), and one or more additional layers of alternating CrN (46) and chromium (48) layers.

2. A method of preparing a composite silicon carbide cladding for use in a light water nuclear reactor, comprising:
providing a silicon carbide substrate (21) having an outer surface (25), the silicon carbide substrate (21) comprising a silicon carbide ceramic matrix composite; and
depositing a coating on the outer surface (25) of the silicon carbide substrate (21),
**characterized in that**
depositing the coating comprises:
depositing an aluminum coating (23) on the outer surface (25) of the silicon carbide substrate (21), and depositing a FeCrAl alloy coating (28) on the aluminum coating (23); or
depositing a CrN layer (41) on the outer surface (25) of the silicon carbide substrate (21) and depositing a chromium layer (44) on the CrN layer (41), and depositing one or more additional layers of alternating CrN (46) and chromium (48) layers thereon.

3. The method of claim 2, wherein, when the method includes depositing the aluminum coating (23) on the outer surface (25) of the silicon carbide substrate (21) and depositing a FeCrAl alloy coating (28) on the aluminum coating (23), the method further comprises heat treating the coating.

4. The method of claim 3, further comprising forming an intermixed coating (30) comprising Al₄C₃+Si and Fe-Al alloy applied to the outer surface (25) of the silicon carbide substrate (21), a FeCrAl alloy coating (28) applied to the intermixed coating (30), and a Cr₂O₃ coating (32) applied to the FeCrAl alloy coating (28).

5. The method of claim 3, wherein the heat treating is conducted at a temperature from 500 to 600 °C.

6. The method of any one of claims 2 to 5, wherein depositing the coating comprises a process selected from the group consisting of cold spray, thermal spray, physical vapor deposition, DC reactive sputtering, and slurry coating.

## Patentansprüche

1. Zusammengesetzte Siliziumkarbidauflage in einem Leichtwassernuklearreaktor, umfassend:
ein Siliziumkarbidsubstrat (21) mit einer Außenfläche (25), wobei das Siliziumkarbidsubstrat (21) einen Siliziumkarbidkeramikmatrix-Verbundstoff umfasst; und
eine auf die Außenfläche (25) des Siliziumkarbidsubstrats (21) aufgebrachte Beschichtung,
**dadurch gekennzeichnet, dass**
die Beschichtung umfasst:
eine Aluminiumbeschichtung (23), aufgebracht auf die Außenfläche (25) des Siliziumkarbidsubstrats (21), und eine Beschichtung (28) aus FeCrAl-Legierung, aufgebracht auf die Aluminiumbeschichtung (23); oder
eine gemischte Beschichtung (30), umfassend Al₄C₃+Si und Fe-Al-Legierung, aufgebracht auf die Außenfläche (25) des Siliziumkarbidsubstrats (21), eine FeCrAI-Legierungsbeschichtung (28), aufgebracht auf die gemischte Beschichtung (30), und eine Cr₂O₃-Beschichtung (32), aufgebracht auf die Beschichtung (28) aus FeCrAl-Legierung; oder
eine CrN-Schicht (41), aufgebracht auf die Außenfläche (25) des Siliziumkarbidsubstrats (21), und eine Chromschicht (44), aufgebracht auf die CrN-Schicht (41), und eine oder mehrere zusätzliche Schichten wechselnder Schichten von CrN (46) und Chrom (48).

2. Verfahren zur Herstellung einer zusammengesetzten Siliziumkarbidauflage zur Verwendung in einem Leichtwassernuklearreaktor, umfassend:
Bereitstellen eines Siliziumkarbidsubstrats (21) mit einer Außenfläche (25), wobei das Siliziumkarbidsubstrat (21) einen Siliziumkarbidkeramikmatrix-Verbundstoff umfasst; und
Ablagern einer Beschichtung auf der Außenfläche (25) des Siliziumkarbidsubstrats (21),
**dadurch gekennzeichnet, dass**
das Ablagern der Beschichtung umfasst:
Ablagern einer Aluminiumbeschichtung (23) auf der Außenfläche (25) des Siliziumkarbidsubstrats (21) und Ablagern einer Beschichtung (28) aus FeCrAl-Legierung auf der Aluminiumbeschichtung (23); oder
Ablagern einer CrN-Schicht (41) auf der Außenfläche (25) des Siliziumkarbidsubstrats (21) und Ablagern einer Chromschicht (44) auf der CrN-Schicht (41), und Ablagern einer oder mehrerer zusätzlicher Schichten aus wechselnden Schichten von CrN (46) und Chrom (48) darauf.

3. Verfahren nach Anspruch 2, wobei das Verfahren dann, wenn das Verfahren ein Ablagern der Aluminiumbeschichtung (23) auf der Außenfläche (25) des Siliziumkarbidsubstrats (21) und ein Ablagern der Beschichtung (28) aus FeCrAl-Legierung auf der Aluminiumbeschichtung (23) beinhaltet, das Verfahren ferner ein Wärmebehandeln der Beschichtung umfasst.

4. Verfahren nach Anspruch 3, ferner umfassend das Bilden einer gemischten Beschichtung (30), umfassend Al₄C₃+Si und Fe-Al-Legierung, aufgebracht auf die Außenfläche (25) des Siliziumkarbidsubstrats (21), einer Beschichtung (28) aus FeCrAl-Legierung, aufgebracht auf die gemischte Beschichtung (30), und einer Cr₂O₃-Beschichtung (32), aufgebracht auf die Beschichtung (28) aus FeCrAl-Legierung.

5. Verfahren nach Anspruch 3, wobei die Wärmebehandlung bei einer Temperatur von 500 bis 600 °C durchgeführt wird.

6. Verfahren nach einem der Ansprüche 2 bis 5, wobei das Ablagern der Beschichtung einen Prozess umfasst, der aus der Gruppe ausgewählt ist, die aus Kaltspritzen, thermischem Spritzen, physikalischer Dampfabscheidung, reaktivem Gleichstrom-Sputtern und Schlickerbeschichten besteht.

## Revendications

1. Gainage en carbure de silicium composite dans un réacteur nucléaire à eau légère, comprenant :
un substrat en carbure de silicium (21) possédant une surface extérieure (25), le substrat en carbure de silicium (21) comprenant un composite à matrice céramique en carbure de silicium ; et
un revêtement appliqué à la surface extérieure (25) du substrat en carbure de silicium (21),
**caractérisé en ce que**
le revêtement comprend :
un revêtement en aluminium (23) appliqué à la surface extérieure (25) du substrat en carbure de silicium (21), et un revêtement en alliage de FeCrAl (28) appliqué au revêtement en aluminium (23) ; ou
un revêtement intermédiaire (30) comprenant de l'alliage d'Al₄C₃+Si et de Fe-Al appliqué à la surface extérieure (25) du substrat en carbure de silicium (21), un revêtement en alliage de FeCrAl (28) appliqué au revêtement intermédiaire (30), et un revêtement de Cr₂O₃ (32) appliqué au revêtement en alliage de FeCrAl (28) ; ou
une couche de CrN (41) appliquée à la surface extérieure (25) du substrat en carbure de silicium (21) et une couche de chrome (44) appliquée à la couche de CrN (41), ainsi qu'une ou plusieurs couches supplémentaires de couches de CrN (46) et de chrome (48) en alternance.

2. Méthode de préparation d'un gainage en carbure de silicium composite en vue de l'utilisation dans un réacteur nucléaire à eau légère, comprenant :
la livraison d'un substrat en carbure de silicium (21) possédant une surface extérieure (25), le substrat en carbure de silicium (21) comprenant un composite à matrice céramique en carbure de silicium ; et
le dépôt d'un revêtement sur la surface extérieure (25) du substrat en carbure de silicium (21),
**caractérisée en ce que**
le dépôt du revêtement comprend :
le dépôt d'un revêtement en aluminium (23) sur la surface extérieure (25) du substrat en carbure de silicium (21), et le dépôt d'un revêtement en alliage de FeCrAl (28) sur le revêtement en aluminium (23) ; ou
le dépôt d'une couche de CrN (41) sur la surface extérieure (25) du substrat en carbure de silicium (21) et le dépôt d'une couche de chrome (44) sur la couche de CrN (41), ainsi que le dépôt d'une ou plusieurs couches supplémentaires de couches de CrN (46) et de chrome (48) en alternance.

3. Méthode selon la revendication 2, dans laquelle, lorsque la méthode comporte le dépôt du revêtement en aluminium (23) sur la surface extérieure (25) du substrat en carbure de silicium (21), et le dépôt d'un revêtement en alliage de FeCrAl (28) sur le revêtement en aluminium (23), la méthode comprend par ailleurs le traitement thermique du revêtement.

4. Méthode selon la revendication 3, comprenant par ailleurs la formation d'un revêtement intermédiaire (30) comprenant de l'alliage d'Al₄C₃+Si et de Fe-Al appliqué à la surface extérieure (25) du substrat en carbure de silicium (21), un revêtement en alliage de FeCrAl (28) appliqué au revêtement intermédiaire (30), et un revêtement de Cr₂O₃ (32) appliqué au revêtement en alliage de FeCrAl (28).

5. Méthode selon la revendication 3, dans laquelle le traitement thermique est réalisé à une température de 500 à 600 °C.

6. Méthode selon une quelconque des revendications 2 à 5, dans laquelle le dépôt du revêtement comprend un processus sélectionné à partir du groupe se composant de la pulvérisation à froid, de la pulvérisation thermique, du dépôt physique par phase vapeur, de la pulvérisation réactive à courant continu et du revêtement en coulis.
